# EUROPEAN PATENT APPLICATION

(11) **EP 4 632 391 A1**
(43) Date of publication of application: **15.10.2025**
(21) Application number: 23900218.1
(22) Date of filing: 21.06.2023
(51) Int. Cl.: G01R 1/067, G01R 1/073, G01R 31/26, G01R 31/28, H01L 21/66

(54) **PROBE AND ELECTRICAL CONNECTION DEVICE**

(30) Priority: 05.12.2022 JP 2022194489
(71) Applicant: Kabushiki Kaisha Nihon Micronics, Musashino-shi Tokyo 180-8508 (JP)
(72) Inventor: HAYASHIZAKI Takayuki, Musashino-shi, Tokyo 180-8508 (JP); KON Mizuho, Musashino-shi, Tokyo 180-8508 (JP); TOYODA Misaki, Musashino-shi, Tokyo 180-8508 (JP)
(74) Representative: Samson & Partner Patentanwälte mbB
(86) International application number: PCT/JP2023/022990
(87) International publication number: WO 2024/122086

(57) **Abstract**

A probe is held by a probe head by being inserted into a guide hole of a guide plate included in the probe head. The probe includes: a column-shaped base material; and a protective material, which covers at least a portion of a side surface of a region of the base material passing through the guide hole, having a higher hardness than the base material. The protective material which covers a region of the base material passing through the same guide hole is divided into a plurality of parts along an axial direction of the base material.

## Description

### TECHNICAL FIELD

The present invention relates to a probe and an electrical connection apparatus used for inspecting the electrical characteristics of an inspection object.

### BACKGROUND ART

In order to inspect the electrical characteristics of an inspection object such as a semiconductor integrated circuit in a wafer state, an electrical connection apparatus including a probe is used. In inspection using a probe, one end of the probe is brought into contact with an electrode pad of the inspection object, and the other end of the probe is brought into contact with a terminal (hereinafter, referred to as "land") arranged on a printed circuit board or the like. The land is electrically connected to an inspection device such as a tester.

In inspection of an inspection object, after the probe is brought into contact with an electrode pad, the electrical connection apparatus and the inspection object are brought closer to each other (overdrive), thereby curving the probe by elastic deformation. As the probe is curved in this way, the probe can be stably brought into contact with the electrode pad and the land by the elastic force of the probe.

### CITATION LIST

### PATENT LITERATURE

Patent Literature 1: JP 2018-91870 A

### SUMMARY OF INVENTION

### PROBLEMS TO BE SOLVED BY INVENTION

A probe is supported by a probe head having a plurality of guide plates in a state in which the probe is penetrated through the guide holes formed in the guide plates. In order to prevent the probe from being damaged due to contact between the inner wall surface or opening of the guide holes and the side surface of the probe, the circumference of the side surface of the region of the probe penetrating through the guide holes is covered by a protective material made of a material harder than the base material of the probe. However, the stress applied to the probe that is caused by formation of the protective material may cause warpage of the probe.

An object of the present invention is to provide a probe and an electrical connection apparatus capable of suppressing warpage of the probe that is caused by formation of a protective material that covers the side surface of the probe.

### SOLUTION TO SOLVE PROBLEMS

A prove according to an aspect of the present invention is held by a probe head by being inserted into a guide hole of a guide plate included in the probe head. The probe includes: a column-shaped base material; and a protective material, which covers at least a portion of a side surface of a region of the base material passing through the guide hole, having a higher hardness than the base material. The protective material which covers a region of the base material passing through the same guide hole is divided into a plurality of parts along an axial direction of the base material.

### EFFECTS OF INVENTION

The present invention makes it possible to provide a probe and an electrical connection apparatus capable of suppressing warpage of the probe that is caused by formation of a protective material that covers the side surface of the probe.

### BRIEF DESCRIPTION OF DRAWINGS

[FIG. 1] FIG. 1 is a schematic diagram illustrating a configuration of an electrical connection apparatus according to an embodiment of the present invention.
[FIG. 2] FIG. 2 is a schematic diagram illustrating a configuration of a probe according to an embodiment of the present invention.
[FIG. 3] FIG. 3 is a schematic cross-sectional view taken along the III-III direction of FIG. 2.
[FIG. 4] FIG. 4 is a schematic diagram illustrating an example of a state of a manufacturing process of the probe according to the embodiment of the present invention.
[FIG. 5A] FIG. 5A is a schematic diagram illustrating a configuration of a probe according to a first modified example of the embodiment of the present invention.
[FIG. 5B] FIG. 5B is a schematic cross-sectional view taken along the V-V direction of FIG. 5A.
[FIG. 6] FIG. 6 is a schematic diagram illustrating a configuration of an electrical connection apparatus according to a second modified example of the embodiment of the present invention.
[FIG. 7] FIG. 7 is a schematic cross-sectional view taken along the VII-VII direction of FIG. 6.

### DESCRIPTION OF EMBODIMENT

An embodiment of the present invention will be described below with reference to the drawings. The same or similar elements illustrated in the drawings are denoted by the same or similar reference numerals. However, the drawings are illustrated schematically, and it should be noted that the proportions of the thicknesses or lengths of the respective parts and so forth are not drawn to scale. It should also be understood that the relationships or proportions of the dimensions between the respective drawings are different from each other in some elements. The embodiment described below exemplify a device and a method for embodying a technical idea of the present invention. In the embodiment of the present invention, the material, shape, structure, arrangement, manufacturing method and the like of the components are not limited to the following description.

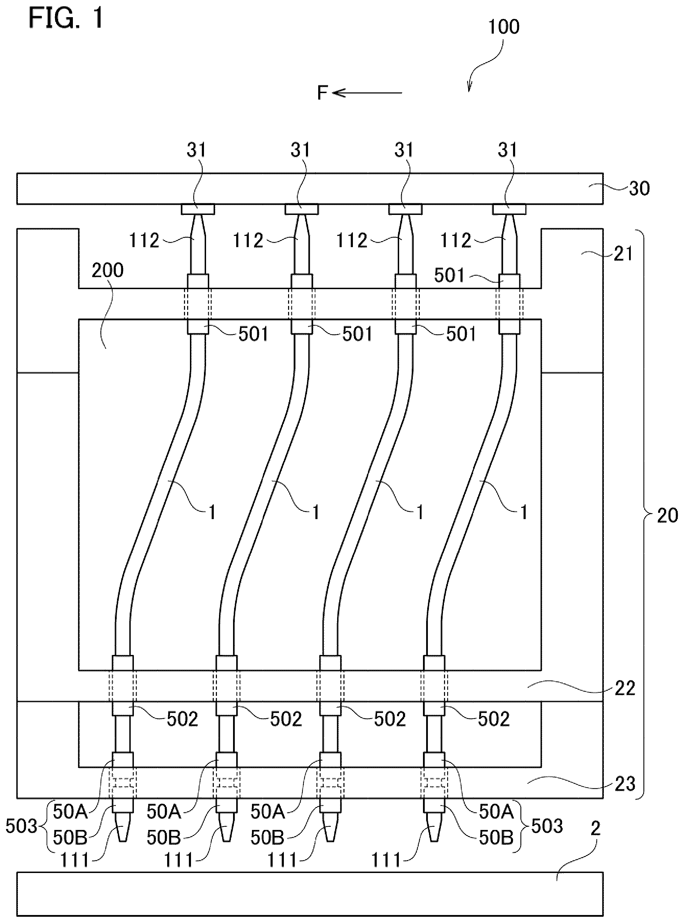

An electrical connection apparatus 100 according to an embodiment of the present invention illustrated in FIG. 1 is used for inspecting the electrical characteristics of an inspection object 2. In the electrical connection apparatus 100, the probe 1 is held by a probe head 20. Specifically, the probe 1 is inserted into a guide hole of a first guide plate 21, a guide hole of a second guide plate 22, and a guide hole of a third guide plate 23 which are included in the probe head 20, and thus a plurality of probes 1 are held by the probe head 20. The probe head 20 has a configuration in which the first guide plate 21, the second guide plate 22, and the third guide plate 23 are arranged apart from each other in the surface normal direction of the main surfaces of the guide plates. In the following description, when not limiting the first guide plate 21, the second guide plate 22, and the third guide plate 23 individually, they are referred to as a guide plate.

The probe 1 has a first contact part 111 which is one end and a second contact part 112 which is the other end. At the time of inspection of the inspection object 2, the first contact part 111 of the probe 1 comes into contact with an electrode pad of the inspection object 2 (not illustrated). The second contact part 112 of the probe 1 comes into contact with a land 31 of a substrate 30. The land 31 is electrically connected to an inspection device such as an IC tester (not illustrated). The first contact part 111 passes through the guide holes through which a second guide plate 22 and a third guide plate 23 are penetrated. The second contact part 112 passes through the guide hole through which a first guide plate 21 is penetrated.

The probe 1 includes a column-shaped base material, and a protective material 50, which covers at least a portion of a side surface of a region of the base material passing through the guide hole, having a higher hardness than the base material. The probe 1 illustrated in FIG. 1 includes a first protective material 501 covering the outer periphery of the region passing through the first guide plate 21, a second protective material 502 covering the outer periphery of the region passing through the second guide plate 22, and a third protective material 503 covering the outer periphery of the region passing through the third guide plate 23. In the following description, when not limiting the first protective material 501, the second protective material 502, and the third protective material 503 individually, they are referred to as a protective material 50.

The protective material 50 prevents the probe from being damaged due to contact between the side surface of the guide hole and the probe 1. "The side surface" of the guide hole includes the inner wall surface and the opening of the guide hole. In the probe 1 according to the embodiment, the protective material 50 which covers the region of the base material 10 passing through the same guide hole is divided into a plurality of parts along the axial direction of the base material 10 in at least any of a plurality of regions penetrating through the guide plate. In the probe 1 illustrated in FIG. 1, the third protective material 503 is divided into a first protective part 50A and a second protective part 50B.

As illustrated in FIG. 1, in the probe head 20, regarding the guide hole through which the same probe 1 penetrates, the position of the guide hole of the second guide plate 22 is arranged so as to be shifted in a direction F parallel to the main surface of the first guide plate 21 with respect to the guide hole of the first guide plate 21. In the following description, an arrangement in which the position of the guide hole is shifted is referred to as an "offset arrangement". Further, the direction F in which the position of the guide hole is shifted is referred to as an "offset direction". Due to the offset arrangement, the probe 1 is curved between the first guide plate 21 and the second guide plate 22. That is, in a hollow region 200 between the first guide plate 21 and the second guide plate 22, the probe 1 is in a curved state by elastic deformation. The position of the guide hole of the second guide plate 22 and the position of the guide hole of the third guide plate 23 coincide with each other when viewed from the surface normal direction of the guide plates.

Since the guide hole of the first guide plate 21 and the guide hole of the second guide plate 22 are arranged in an offset manner, when the first contact part 111 of the probe 1 comes into contact with the inspection object 2, the probe 1 buckles in the hollow region 200. That is, in a state in which the probe 1 comes into contact with the inspection object 2

(contact state), the probe 1 is further curved by deflection deformation from the curved shape in a state in which the probe 1 is not into contact with the inspection object 2 (non-contact state). As the probe 1 is further curved in this way, the probe 1 comes into contact with the inspection object 2 with a predetermined pushing force. Therefore, the offset arrangement makes it possible to measure the electrical characteristics of the inspection object 2 stably using the probe 1. In the non-contact state, the probe 1 has elasticity to return to the shape before coming into contact with the inspection object 2.

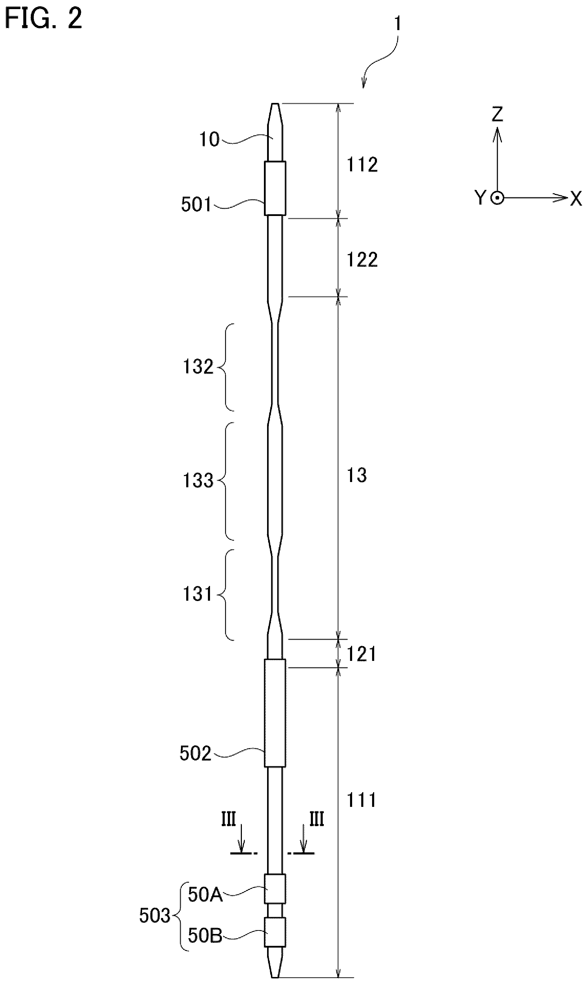

The details of the probe 1 will be described below with reference to FIG. 2.

The probe 1 according to the embodiment illustrated in FIG. 2 has a column shape including a structure in which the first contact part 111, a first connection part 121, a curved part 13, a second connection part 122, and the second contact part 112 are connected in order along the axial direction. In the following description, when not limiting the first contact part 111 and the second contact part 112 individually, they are referred to as a contact part 11. Further, when not limiting the first connection part 121 and the second connection part 122 individually, they are referred to as a connection part 12. In other words, the probe 1 includes the contact part 11, the curved part 13, and the connection part 12 configured to connect the contact part 11 and the curved part 13.

The first connection part 121 connects the first contact part 111 and the curved part 13. The second connection part 122 connects the second contact part 112 and the curved part 13. The tip of the first contact part 111 comes into contact with an inspection object in inspection. The tip of the second contact part 112 comes into contact with a land in inspection of the inspection object. The probe 1 is curved by elastic deformation at the time of inspection of the inspection object.

In the description of the embodiment of the present invention, the X, Y and Z directions are defined as illustrated in FIG. 2. In FIG. 2, the X direction is parallel to the left-right direction of the page space, the Y direction is parallel to the depth direction of the page space, and the Z direction is parallel to the up-down direction of the page space. The axial direction of the probe 1 is along the Z direction. In the following description, a case will be described in which the probe 1 has a rectangular cross-section perpendicular to the axial direction. Further, the X direction is defined as the width direction of the probe 1, and the Y direction is defined as the thickness direction of the probe 1.

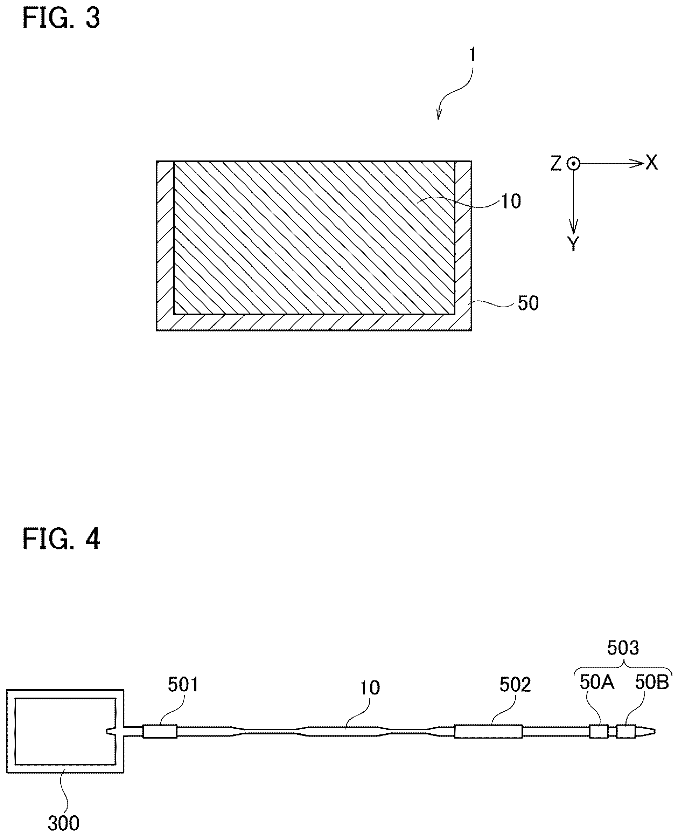

FIG. 3 illustrates a structure of the cross-section of the probe 1 perpendicular to the axial direction along the III-III direction of FIG. 2 (hereinafter, simply referred to as "cross-section"). In the probe 1 illustrated in FIG. 3, a case has been described as an example in which one long side and two short sides of the four side surfaces of the base material 10 are covered by the protective material 50. As illustrated in FIG. 3, the three side surfaces of the base material 10 having a rectangular cross-section may be covered by the protective material 50, and the remaining one side surface may not be covered by the protective material 50. Alternatively, the side surfaces of the base material 10 may be surrounded by the protective material 50.

The probe 1 according to the embodiment makes it possible to suppress the damage to the probe 1 due to contact with the side surface of the guide hole by arranging the protective material 50 on the side surface of the base material 10. For example, nickel (Ni) or nickel alloy is used for the base material 10. For example, rhodium (Rh) or the like is suitably used for the protective material 50. Alternatively, diamond like carbon (DLC) or the like may be used for the protective material 50. The base material 10 may be a single material, or a layered structure of different materials.

In the probe 1, as illustrated in FIG. 2, the area of the cross-section of the region of the curved part 13 connected to the connection part 12 may be smaller than the area of the cross-section of the other region of the curved part 13. In the following description, the region of the curved part 13 connected to the connection part 12 is also referred to as a "connection region". Further, in the following description, the remaining region of the curved part 13 excluding the connection region is also referred to as an "intermediate region". The curved part 13 illustrated in FIG. 2 includes an intermediate region 133, a first connection region 131 connected to one end of the intermediate region 133, and a second connection region 132 connected to the other end of the intermediate region 133. The first connection region 131 is connected to the first connection part 121, and the second connection region 132 is connected to the second connection part 122. In the following description, when not limiting the first connection region 131 and the second connection region 132 individually, they are referred to as a connection region 130.

In the curved part 13, as the area of the cross-section of the connection region 130 is set to be smaller than that of the intermediate region 133, when the probe 1 is curved, the connection region 130 is curved particularly greatly between the intermediate region 133 and the connection part 12. Therefore, the straightness of the contact part 11 which is connected to the connection part 12 on the side opposite to the curved part 13 can be ensured. For example, as illustrated in FIG. 2, as the width of the connection region 130 is set to be smaller than that of the intermediate region 133 in the X direction, the area of the cross-section of the connection region 130 may be smaller than that of the intermediate region 133. At this time, the thickness of the curved part 13 is constant when viewed from the X direction.

In a case where the curved part 13 includes the intermediate region 133 and the connection region 130 when the probe 1 is curved in the contact state in which the probe 1 is in contact with the inspection object 2, the probe 1 is greatly curved, particularly in the connection region 130. This makes it possible for the contact part 11 to move linearly along the guide hole. As a result, the contact between the side surface of the guide hole and the contact part 11 can be suppressed. However, if the contact between the side surface of the guide hole and the contact part 11 can be suppressed even if the curved part 13 does not include the connection region 130, the diameter of the curved part 13 may be constant.

The protective material 50 may cover a portion of the connection part 12 beyond the connected portion between the contact part 11 and the connection part 12. That is, the region of the connection part 12 near the contact part 11 may be covered by the protective material 50, and the region of the connection part 12 near the curved part 13 may not be covered by the protective material 50. By covering the region of the connection part 12 near the contact part 11 with the protective material 50, even if a portion of the connection part 12 passes through the inner side of the guide hole, the damage to the probe 1 due to contact with the side surface of the guide hole can be suppressed.

The protective material 50 is divided so as to cover the region of the base material 10 passing through the opening of the guide hole according to the range of the region of the probe 1 passing through the guide hole. In other words, the region of the base material 10 in which the protective material 50 is arranged is the region passing through the guide hole at the time of inspection of the inspection object or at the time of non-inspection of the inspection object. For example, in a state in which the base material 10 is curved at the inner side of the probe head 20 due to the offset arrangement, the region of the base material 10 passing through the guide hole is covered by the protective material 50. Further, the region of the base material 10 that passes through the guide hole is covered by the protective material 50 by performing overdrive so as to press the probe 1 against the inspection object at the time of inspection of the inspection object.

For example, the protective material 50 is divided in consideration of the length of the guide hole along the axial direction of the probe 1 (for example, 250 µm), and the length of a stroke due to the curvedness of the probe 1 (for example, 120 µm). Herein, the "stroke" is the amount of change in a range which the probe 1 passes through the guide hole between the contact state and the non-contact state.

For example, the offset direction is the direction to which the long sides of the cross-section of the base material 10 are oriented. In this case, as illustrated in FIG. 3, in the base material 10 in which three side surfaces are covered by the protective material 50, the protective material 50 is arranged on at least one of the side surfaces oriented in the direction parallel to the offset direction. In contrast, among the side surfaces oriented in the direction parallel to the offset direction, the side surface oriented in the direction opposite to the side surface where the protective material 50 is arranged may not be covered by the protective material 50. In other words, the protective material 50 may be formed on the remaining side surface of the base material 10 which excludes either one of the side surface oriented in the offset direction and the side surface oriented in the direction opposite to the offset direction.

In recent years, probe cards have been required to have a narrow pitch, which reduces the distance between probes. In addition, the diameter of probes has been reduced to prevent short circuits with adjacent probes. By covering the side surface of the base material 10 that may come into contact with the guide plate with the protective material 50, it is possible to prevent the probe 1 from increasing in diameter, and to prevent the base material 10 from being damaged due to contact with the guide hole. For example, according to the probe 1 of the present embodiment, the remaining side surface of the base material 10 which excludes either one of the side surface oriented in the offset direction and the side surface oriented in the direction opposite to the offset direction is covered by the protective material 50. In contrast, the base material 10 is exposed on the side surface oriented in the direction opposite to the offset direction. Accordingly, by covering three side surfaces with the protective material 50 and exposing the base material 10 on one side surface, the surface of the base material 10 is covered by the protective material 50. This makes it possible to prevent the probe 1 from increasing in diameter, and to prevent the base material 10 from being damaged due to contact with the guide hole.

Note that it is not limited to covering only three side surfaces of the base material 10 with the protective material 50. By embedding the protective material 50 in the base material 10, it is also possible to prevent the probe 1 from increasing in diameter, and to prevent the base material 10 from being damaged due to contact with the guide hole. The probe 1 is not limited to having either one of a structure in which the surface of the base material 10 is covered by the protective material 50, and a structure in which the protective material 50 is embedded in the base material 10.

The probe 1 is formed, for example, by patterning the material of the base material 10 formed on a plate-like base into a predetermined shape by etching. In the process of manufacturing the probe 1, the protective material 50 is formed on the surface of the base material 10 by plating or the like. At this time, for example, as illustrated in the top view of FIG. 4, the base material 10 is formed in a state in which one end thereof is supported by the support base 300 and floats above the base (not illustrated). Therefore, the base material 10 is susceptible to the stress from the second contact part 112 integrated with the support base 300 toward the first contact part 111. That is, the region of the first contact part 111 on which the protective material 50 is plated is prone to warpage due to the influence of stress caused by plating. In particular, the warpage tends to occur in the probe 1 after the step of forming the protective material 50. Further, even after the manufacturing step, the region of the probe 1 covered by the protective material 50 is prone to warpage. In contrast, in the probe 1 according to the embodiment, the influence of stress on the base material 10 is reduced by dividing the protective material 50, thereby making it possible to suppress the occurrence of warpage. In the probe 1, the case has been described as an example in which the third protective material 503 formed around the first contact part 111, which is particularly prone to warpage, is divided.

As described above, in the electrical connection apparatus 100, the protective material 50 having a higher hardness than the contact part 11 is arranged around the region of the contact part 11 of the probe 1 passing through the guide hole. Thus, according to the electrical connection apparatus 100, the damage to the probe 1 due to contact with the side surface of the guide hole can be suppressed. Meanwhile, as the region where the protective material 50 is continuously formed along the axial direction of the base material 10 is longer, the warpage tends to occur in the probe 1. In contrast, in the electrical connection apparatus 100 according to the embodiment, the protective material 50 which covers the region passing through the same guide hole in the probe 1 is divided into a plurality of parts along the axial direction of the base material 10. This makes it possible to suppress warpage of the probe 1 that is caused by the formation of the protective material 50.

### <First modified example>

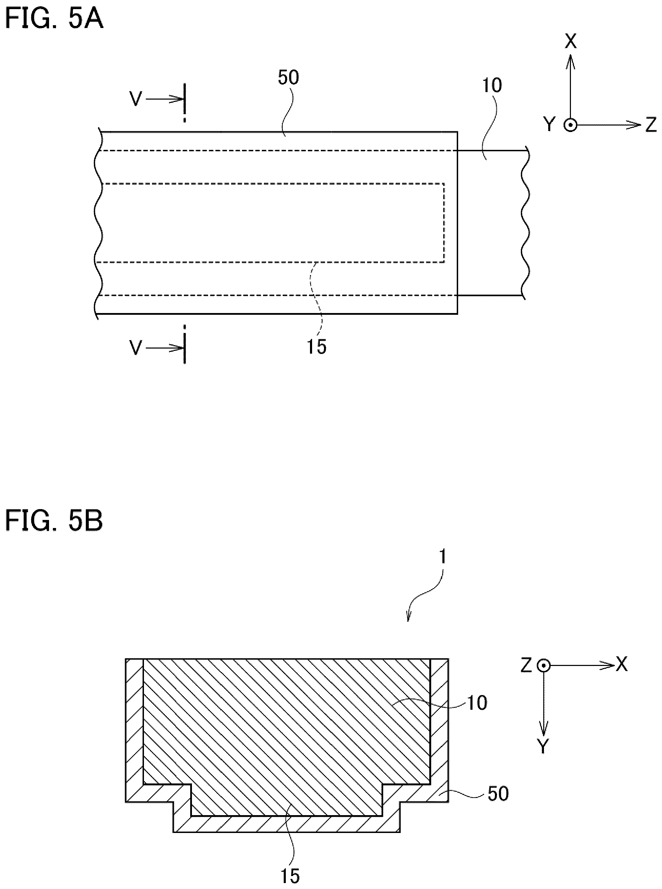

A probe 1 according to a first modified example illustrated in FIGS. 5A and 5B has a configuration in which a convex part 15 extending along the axial direction is provided on one side surface of the base material 10. By forming the convex part 15 on the side surface of the base material 10, the rigidity of the base material 10 can be increased, thereby suppressing the occurrence of warpage of the probe 1. Since the convex part 15 is arranged on the side surface of the base material 10, the rigidity of the base material 10 is further improved, and thus the portion of the probe 1 inserted into the guide hole is hardly curved. For example, the convex part 15 may be formed on the side surface of the base material 10 oriented in the offset direction (hereinafter, it is referred to as "offset surface"). The reason why the convex part 15 is formed on the offset surface is that, when the base material 10 has a rectangular cross-sectional shape, warpage generally tends to occur on the side surface, which is the long side that generally becomes the offset surface. The protective material 50 is arranged on the base material 10 by covering the surface of the convex part 15 including the end surface oriented in the axial direction.

It is preferable that the convex part 15 does not extend to the tip of the base material 10. Since the convex part 15 is not formed on the tip of the base material 10, it is possible to prevent the end surface of the convex part 15 from abutting against the opening of the guide hole in the process of inserting the probe 1 into the guide hole of the probe head 20, thereby preventing the insertion of the probe 1 into the guide hole from being hindered. The convex part 15 may be formed only in the region covered by the protective material 50.

### <Second modified example>

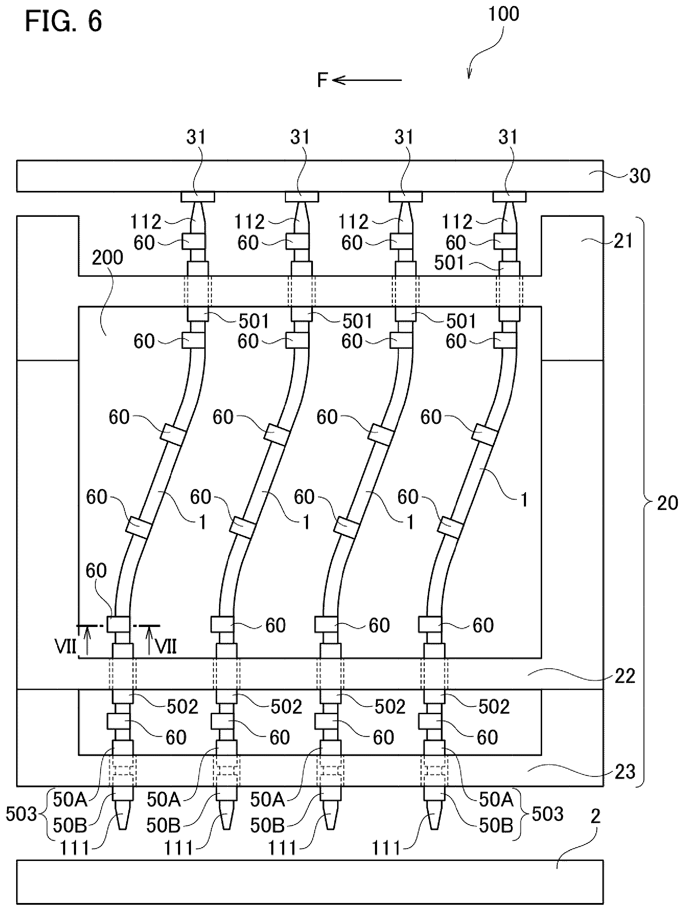

In the electrical connection apparatus 100 according to a second modified example illustrated in FIG. 6, a plurality of insulating covering materials 60 are arranged apart from each other on the surface of the probe 1 along the axial direction of the probe 1. The covering materials 60 are arranged in the remaining regions of the regions in which the protective materials 50 are arranged.

When the probe 1 buckles at the inner inside of the probe head 20 at the time of inspection of an inspection object, a short circuit between the probes may occur. In the electrical connection apparatus 100 illustrated in FIG. 6, the insulating covering materials 60 arranged on the surface of the probe 1 are brought into contact with the adjacent probes 1, thereby preventing a short circuit between the probes.

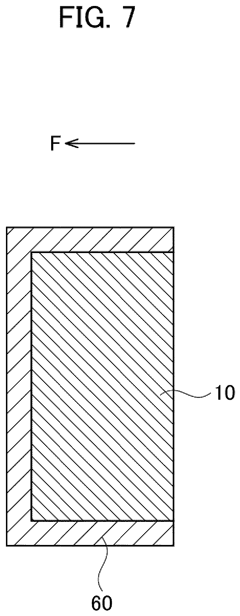

It is preferable that the covering material 60 be arranged on the offset surface of the probe 1, or on the side surface oriented in the direction opposite to the offset surface. For example, as illustrated in FIG. 7, the covering material 60 may be continuously arranged on the offset surface of the base material 10 having a rectangular cross-section and on two side surfaces adjacent to the offset surface. Alternatively, the covering material 60 may be arranged over the entire circumference of the probe 1.

It is preferable that each of the covering materials 60 is intermittently arranged, including at least the curved portion, in the portion passing through the hollow region 200 of the probe 1. In contrast, if the surface of the base material 10 is continuously covered by the covering materials 60 along the axial direction from the first contact part 111 to the second contact part 112, the warpage of the probe 1 tends to occur. However, in the probe 1 illustrated in FIG. 6, the warpage of the probe 1 is suppressed by intermittently arranging the covering materials 60 along the axial direction.

Meanwhile, in order to set the probe 1 in the probe head 20, the probe 1 is made to penetrate through the guide holes of the guide plates. For example, the probe 1 is made to penetrate continuously through the guide holes of the guide plates in a state in which the center axes of the guide holes of all the guide plates are aligned. Therefore, the sum of the outer diameter of the probe 1 and the thickness of the covering materials 60 is set smaller than the inner diameters of the guide holes. That is, the thickness of the covering materials 60 is set to the thickness in a range that ensures a clearance between the sum of the outer diameter of the probe 1 and the thickness of the covering materials 60 and the inner diameter of the guide holes, and to the thickness that prevents a short circuit between the probes.

The material of the covering material 60 may be, for example, resin, glass fiber, permanent resist, ceramic vapor deposition, or the like. In order to form the covering material 60 at a predetermined position on the surface of the probe 1, for example, the covering material 60 may be formed over the entire surface of the probe 1, and then the covering material 60 may be patterned using a photolithography technique or the like.

### (Other embodiments)

The embodiment of the present invention has been described as above, but the statements and drawings forming part of this disclosure should not be understood as limiting the invention. Various alternative embodiments, examples, and operating techniques will be apparent to those skilled in the art from this disclosure.

For example, although the case has been described as an example in which the protective material 50 passing through the same guide hole is divided into two parts, the protective material 50 may be divided into three or more parts. In this respect, the protective material 50 is divided in such a way that the region of the base material 10 passing through the opening of the guide hole of the guide plate is covered by the protective material 50. In addition, although the case has been described an example in which the third protective material 503 is divided, the first protective material 501 and the second protective material 502 may also be divided into a plurality of parts.

Further, although the case has been described above in which the base material 10 has a rectangular cross-sectional shape; however, the base material 10 may have a different cross-sectional shape. For example, the base material 10 may have a polygonal cross-sectional shape other than a rectangular cross-sectional shape. No matter what shape the cross-section of the base material 10 has, the damage to the probe 1 due to contact with the side surface of the guide hole can be suppressed by covering the side surface of the region of the base material 10 passing through the guide hole with the protective material 50. The occurrence of warpage of the probe 1 can be suppressed by dividing the protective material 50 passing through the same guide hole into a plurality of parts.

Although the case has been described in which the probe head 20 includes three guide plates, the number of guide plates of the probe head 20 is not limited to three. For example, the number of guide plates of the probe head 20 may be two or more than three. Regardless of the number of guide plates of the probe head 20, it is preferable to form the protective material 50 on the side surface of the region of the base material 10 passing through the guide hole of each guide plate, and to divide the protective material 50 passing through the same guide hole into a plurality of parts.

Thus, the present invention will of course include various embodiments and the like which are not described herein.

### REFERENCE SIGNS LIST

- 1: Probe
- 10: Base material
- 15: Convex part
- 20: Probe head
- 21: First guide plate
- 22: Second guide plate
- 23: Third guide plate
- 30: Substrate
- 31: Land
- 50: Protective material
- 60: Covering material
- 501: First protective material
- 502: Second protective material
- 503: Third protective material
- 50A: First protective part
- 50B: Second protective part
- 100: Electrical connection apparatus

## Claims

1. A probe that is held by a probe head by being inserted into a guide hole of a guide plate included in the probe head, and used for inspecting electrical characteristics of an inspection object, the probe comprising:
a column-shaped base material; and
a protective material, which covers at least a portion of a side surface of a region of the base material passing through the guide hole, having a higher hardness than the base material, wherein
the protective material which covers a region of the base material passing through the same guide hole is divided into a plurality of parts along an axial direction of the base material.

2. The probe according to claim 1, wherein
the protective material is divided in such a way that a region of the base material passing through an opening of the guide plate is covered by the protective material.

3. The probe according to claim 1, wherein
a cross-section of the base material perpendicular to the axial direction has a rectangular shape, and
at least three side surfaces of the base material are covered by the protective material.

4. The probe according to claim 1, wherein
a convex part extending along the axial direction is formed on a side surface of the base material, and
the protective material is arranged on the base material by covering a surface of the convex part including an end surface oriented in the axial direction.

5. An electrical connection apparatus comprising:
the probe head having a configuration in which a first guide plate and a second guide plate, each having the guide hole formed therein, are arranged apart from each other; and
a probe according to any one of claims 1 to 4, which is held by the probe head by being inserted into the guide hole, wherein
regarding the guide hole through which the same probe penetrates, a position of the guide hole of the second guide plate is arranged in an offset manner so as to be shifted in an offset direction parallel to a main surface of the first guide plate with respect to the guide hole of the first guide plate, and
the probe is held in a curved state between the first guide plate and the second guide plate.

6. The electrical connection apparatus according to claim 5, wherein
a cross-section of the base material of the probe perpendicular to the axial direction has a rectangular shape, and
one side of a side surface of the base material oriented in a direction parallel to the offset direction is covered by the protective material, and the other side thereof is not covered by the protective material.
